# EUROPEAN PATENT APPLICATION

(11) **EP 4 130 764 A1**
(43) Date of publication of application: **08.02.2023**
(21) Application number: 21781686.7
(22) Date of filing: 02.04.2021
(51) Int. Cl.: G01R 31/00

(54) **TEST SYSTEM AND TEST METHOD FOR CONVERTER STATION IN FLEXIBLE DIRECT CURRENT TRANSMISSION**

(30) Priority: 03.04.2020 CN 202010259335; 03.04.2020 CN 202010260128
(71) Applicant: NR ELECTRIC CO., LTD., Jiangning Nanjing, Jiangsu 211102 (CN); NR Engineering Co., Ltd., Nanjing, Jiangsu 211102 (CN)
(72) Inventor: LI, Gang, Nanjing Jiangsu 211102 (CN); TIAN, Jie, Nanjing Jiangsu 211102 (CN); LI, Haiying, Nanjing Jiangsu 211102 (CN); LU, Yu, Nanjing Jiangsu 211102 (CN); DONG, Yunlong, Nanjing Jiangsu 211102 (CN); ZOU, Kaikai, Nanjing Jiangsu 211102 (CN); LI, Jianchun, Nanjing Jiangsu 211102 (CN); WANG, Xianrong, Nanjing Jiangsu 211102 (CN); ZHAN, Changjiang, Nanjing Jiangsu 211102 (CN); HU, Xianlai, Nanjing Jiangsu 211102 (CN)
(74) Representative: Cabinet Bleger-Rhein-Poupon
(86) International application number: PCT/CN2021/085235
(87) International publication number: WO 2021/197465

(57) **Abstract**

Disclosed are a test system (2000, 3000, 4000, 5000, 8000, 9000) and a test method for a flexible DC transmission converter station (200). The test system (2000, 3000, 4000, 5000, 8000, 9000) comprises: a test power supply (2100) at a test site; a voltage transforming device connected to the test power supply (2100) through a low-voltage AC switch (2200); a equipment of converter valve and DC field (260) connected to the voltage transforming device; and a resistor assembly (2400) connected between the test power supply (2100) and the voltage transforming device, or between the voltage transforming device and the equipment of converter valve and DC field (260), and comprising a resistor (2410) and a resistor parallel switch (2420) connected in parallel with the resistor (2410). The voltage transforming device may be a three-winding interconnecting transformer (230), or a voltage transforming device comprising a two-winding interconnecting transformer (230), a station transformer (220) and an AC bus (210). The test system makes full use of existing equipment of an offshore converter station (200), and can complete a high-voltage test of the offshore converter station (200) by means of a low-voltage incoming line of an onshore installation test site, without the need of building a test platform.

## Description

### Technical Field

The present application relates to the technical field of flexible DC transmission of power systems, in particular to a test system and a test method for a flexible DC transmission converter station.

### Background

In order to solve the problem of global warming caused by increasing carbon emission, new energy power generation, as a kind of green energy, has attracted more and more attention of governments all over the world. Wind power generation is an important new energy source. Compared with onshore wind power, offshore wind power has the advantages that land resource occupation is avoided, wind resources are more stable and utilization hours are higher. Major countries in the world are developing offshore wind power on a large scale.

Among offshore wind power resources, open sea wind power resources are broader and more stable. In order to obtain more offshore wind energy resources, offshore wind farms are gradually developing towards the open sea. When a wind farm is more than 60 km away from the shore and enters the generalized open sea area, the AC output mode of wind power will gradually lose its cost performance with the increase of power loss, reactive power compensation difficulty and overall cost, so the DC transmission mode is more preferred.

Flexible DC transmission is characterized by fast AGC/AVC, and is especially suitable for offshore wind power transmission. A flexible DC transmission converter station is main equipment in flexible DC transmission. Flexible DC transmission converter stations are usually built on offshore platforms when applied in offshore wind farms. The whole offshore platform generally comprises main equipment space and operator space. Offshore platform space is narrow, even smaller than a football field. Therefore, it is very difficult to test the flexible DC transmission converter station at sea, and there are problems such as long test period and inconvenient supply of living materials. Therefore, the main devices of the offshore converter station need to be transported to the sea for installation after being fully tested on land, so as to reduce working hours at sea.

### Summary

The present application aims to provide a test system for a flexible DC transmission converter station, which makes full use of existing equipment of an offshore converter station, and can complete a high-voltage test of the offshore converter station by means of a low-voltage incoming line of an onshore installation test site, without the need of building a test platform.

According to one aspect of the present application, a test system for a flexible DC transmission converter station is provided, comprising:
a test power supply at a test site;
a voltage transforming device connected to the test power supply through a low-voltage AC switch;
an equipment of converter valve and DC field connected to the voltage transforming device; and
a resistor assembly being connected between the test power supply and the voltage transforming device, or between the voltage transforming device and the equipment of converter valve and DC field, and comprising a resistor and a resistor parallel switch connected in parallel with the resistor.

According to some embodiments of the present application, the voltage transforming device comprises a two-winding interconnecting transformer, a station transformer and an AC bus,
the test power supply is connected to a low-voltage winding of the station transformer through the low-voltage AC switch;
a first winding of the two-winding interconnecting transformer is connected to a high-voltage winding of the station transformer through the AC bus;
the equipment of converter valve and DC field is connected to a second winding of the two-winding interconnecting transformer; and
the resistor assembly is connected between the low-voltage winding of the station transformer and the test power supply, or between the high-voltage winding of the station transformer and the first winding of the two-winding interconnecting transformer, or between the second winding of the two-winding interconnecting transformer and the equipment of converter valve and DC field.

According to some embodiments of the present application, a voltage level of the test power supply matches a voltage level of the low-voltage winding of the station transformer.

According to some embodiments of the present application, the resistor assembly is connected between the high-voltage winding of the station transformer and the first winding of the two-winding interconnecting transformer, the resistor assembly is arranged before or after the AC bus, and a resistance value of the resistor ranges from 50 Ω to 20,000 Ω.

According to some embodiments of the present application, the resistor assembly is connected between the low-voltage winding of the station transformer and the test power supply, the resistor assembly is arranged before or after the low-voltage AC switch, and a resistance value of the resistor ranges from 5 Ω to 2,000 Ω.

According to some embodiments of the present application, the AC bus comprises a bus with an AC switch or a bus without an AC switch.

According to some embodiments of the present application, the AC bus is connected to the first winding of the two-winding interconnecting transformer by 3/2 connection or double-bus connection.

According to some embodiments of the present application, the equipment of converter valve and DC field is connected to the second winding of the two-winding interconnecting transformer through a valve side bus; and
the valve side bus comprises a bus with a valve side switch or a bus without a valve side switch.

According to some embodiments of the present application, the station transformer, the interconnecting transformer, the equipment of converter valve and DC field and the resistor assembly constitute a primary equipment of the test system, and the test system further comprises:
a secondary equipment correspondingly connected to the primary equipment and used for measuring or controlling the primary equipment.

According to another aspect of the present application, a test method for a flexible DC transmission converter station is provided and applied to the above test system, comprising:
monitoring readiness of a primary equipment and a secondary equipment in the test system;
closing the AC switch of an AC bus and a valve side switch;
closing the low-voltage AC switch to charge the primary equipment;
after charging and a delay, closing a resistor parallel switch to further charge the equipment of converter valve and DC field;
testing the primary equipment and the secondary equipment; and
opening the valve side switch, an AC switch of an AC bus, or the low-voltage AC switch for a passive inversion test.

According to some embodiments of the present application, the voltage transformation device comprises a three-winding interconnecting transformer, and the test system further comprises a valve side switch and a valve side bus; and
the test power supply is connected to a third low-voltage winding of the three-winding interconnecting transformer through the low-voltage AC switch;
the valve side switch is connected to a second winding of the three-winding interconnecting transformer;
the valve side bus is connected to the valve side switch;
the equipment of converter valve and DC field is connected to the valve side bus; and
the resistor assembly is connected between the third low-voltage winding of the three-winding interconnecting transformer and the test power supply.

According to some embodiments of the present application, a voltage level of the test power supply matches a voltage level of the third winding of the three-winding interconnecting transformer.

According to some embodiments of the present application, the resistor assembly is arranged before or after the low-voltage AC switch, and a resistance value of the resistor ranges from 5 Ω to 2,000 Ω.

According to some embodiments of the present application, the three-winding interconnecting transformer, the valve side switch, the valve side bus, the equipment of converter valve and DC field and the resistor assembly constitute a primary equipment of the test system, and the test system further comprises:
a secondary equipment correspondingly connected to the primary equipment and used for measuring or controlling the primary equipment.

According to some embodiments of the present application, the test system further comprises:
a grounding device arranged between the voltage transformation device and the equipment of converter valve and DC field.

According to some embodiments of the present application, the grounding device adopts small capacitance grounding or star reactance plus resistance grounding.

According to some embodiments of the present application, the flexible DC transmission converter station is used as an offshore flexible DC transmission converter station.

According to some embodiments of the present application, the test power supply comprises:
one of an existing or boosted 10 kV power supply, 20 kV power supply, 35 kV power supply and 110 kV power supply at a location of the test system.

According to another aspect of the present application, a test method for a flexible DC transmission converter station is provided and applied to the above test system, comprising:
monitoring readiness of a primary equipment and a secondary equipment in the test system;
closing a valve side switch;
closing the low-voltage AC switch to charge the primary equipment;
after charging and a delay, closing a resistor parallel switch to further charge the equipment of converter valve and DC field;
testing the primary equipment and the secondary equipment; and
opening the valve side switch, an AC switch of an AC bus, or the low-voltage AC switch for a passive inversion test.

According to some embodiments of the present application, the delay ranges from 5 s to 500 s.

According to some embodiments of the present application, the test method further comprises: performing an active charging test on the equipment of converter valve and DC field.

The test system for a flexible DC transmission converter station provided by the present application directly uses the main equipment used when an offshore converter station is built on an offshore platform for testing, without additional equipment or changing the existing location. After testing, direct transportation to the sea can be performed. Except for the AC switch, the resistor and the resistor parallel switch, there is no need for additional test sites to build test platforms. In addition, the test system provided by the present application can complete a high-voltage test of the main equipment of the converter station by using a 10 kV low-voltage incoming line of an onshore installation test site for the offshore converter station. Through the test, a system circuit and the main equipment are examined, and wiring and control functions of a converter station control system and the main equipment are verified too, so that problems can be solved on land, and the offshore testing time, engineering test cycle and cost can be reduced. Moreover, the test power supply is placed at a low-voltage end of the incoming line, and the requirement for the capacity of the test power supply is reduced by connecting the resistor assembly in series in the circuit.

Additional aspects and advantages of the present application will be set forth in part in the description that follows, and in part will be obvious from the description that follows, or may be learned by practice of the present application.

### Brief Description of the Drawings

In order to more clearly explain the technical schemes in the embodiments of the present application, the drawings needed in the description of the embodiments will be briefly introduced below. Obviously, the drawings in the following description are only some embodiments of the present application.
Fig. 1 is a diagram showing the composition of an offshore wind power output DC system according to a first exemplary embodiment of the present application.
Fig. 2 is a diagram showing the composition of an offshore wind power output DC system according to a second exemplary embodiment of the present application.
Fig. 3 is a diagram showing the composition of a test system for a flexible DC transmission converter station according to the first exemplary embodiment of the present application.
Fig. 4 is a diagram showing the composition of a test system for a flexible DC transmission converter station according to the second exemplary embodiment of the present application.
Fig. 5 is a diagram showing the composition of a test system for a flexible DC transmission converter station according to a third exemplary embodiment of the present application.
Fig. 6 is a diagram showing the composition of a test system for a flexible DC transmission converter station according to a fourth exemplary embodiment of the present application.
Fig. 7 is a flowchart of a test method for a flexible DC transmission converter station according to the first exemplary embodiment of the present application.
Fig. 8 is a diagram showing the composition of a test system for a flexible DC transmission converter station according to a fifth exemplary embodiment of the present application.
Fig. 9 is a diagram showing the composition of a test system for a flexible DC transmission converter station according to a sixth exemplary embodiment of the present application.
Fig. 10 is a flowchart of a test method for a flexible DC transmission converter station according to the second exemplary embodiment of the present application.

### Detailed Description of Embodiments

Exemplary embodiments will be described more fully below with reference to the accompanying drawings. However, the exemplary embodiments can be implemented in various forms and should not be construed as limited to the embodiments set forth herein. These embodiments are provided to make the present application more thorough and complete, and to fully convey the concept of the exemplary embodiments to those skilled in the art. In the drawings, the same reference signs refer to the same or similar parts, so repeated descriptions will be omitted.

In addition, the described features, structures, or characteristics may be combined in any suitable manner in one or more embodiments. In the following description, numerous specific details are provided to give a thorough understanding of the embodiments of the present application. However, those skilled in the art will realize that the technical scheme of the present application can be practiced without one or more of the specific details, or other methods, components, devices, steps, etc. can be adopted. In other cases, well-known methods, devices, implementations or operations are not shown or described in detail to avoid obscuring aspects of the present application.

It should be understood that although the terms like "first" and "second" may be used herein to describe various components, these components should not be limited by these terms. These terms are used to distinguish one component from another. Therefore, a first component discussed below can be referred to as a second component without departing from the teaching of the concept of the present application. As used herein, the term "and/or" includes any one and all combinations of one or more of the associated listed items.

Those skilled in the art can understand that the drawings are only schematic diagrams of the exemplary embodiments and may not be to scale. The modules or processes in the drawings are not necessarily a must for the implementation of the present application, so they cannot be used to limit the scope of protection of the present application.

In an existing test scheme for an offshore flexible DC transmission converter station, related equipment of the offshore flexible DC transmission converter station is usually tested on an onshore installation test site, such as a dock. The inventor found that testing the offshore flexible DC transmission converter station on the existing onshore installation test site has the following problems.

On one hand, offshore wind power flexible DC transmission projects are generally open sea high-voltage large-capacity projects, and the voltage of a connected AC grid is usually 220 kV. A test power supply for a construction and onshore installation test site usually has an incoming line of 10 kV or 35 kV, which cannot match the high voltage required for the test of the offshore flexible DC transmission converter station. In order to meet the high voltage demand, an additional test circuit is built to provide high voltage power in the prior art. However, the space required for the additional test circuit is limited by the test environment such as the dock. For example, the Chinese patent, CN103033701, discloses a testing device, which is a rectifying circuit and comprises a transformer required by the rectifying device, so the testing device occupies certain space and requires large test power supply capacity.

On the other hand, the onshore construction and installation test sites generally do not have a large-capacity test power supply, so it is hard to meet the test requirements of the offshore flexible DC transmission converter stations.

In addition, according to the existing test scheme using the onshore construction and installation test site, equipment is tested separately, and overall testing of a system cannot be realized.

In view of the technical problems of the existing test scheme using the onshore construction and installation test site, the inventor proposed a test system and test method for a flexible DC transmission converter station, which can not only meet the high voltage demand of the test, but also reduce the requirement for power supply capacity without additional test circuits.

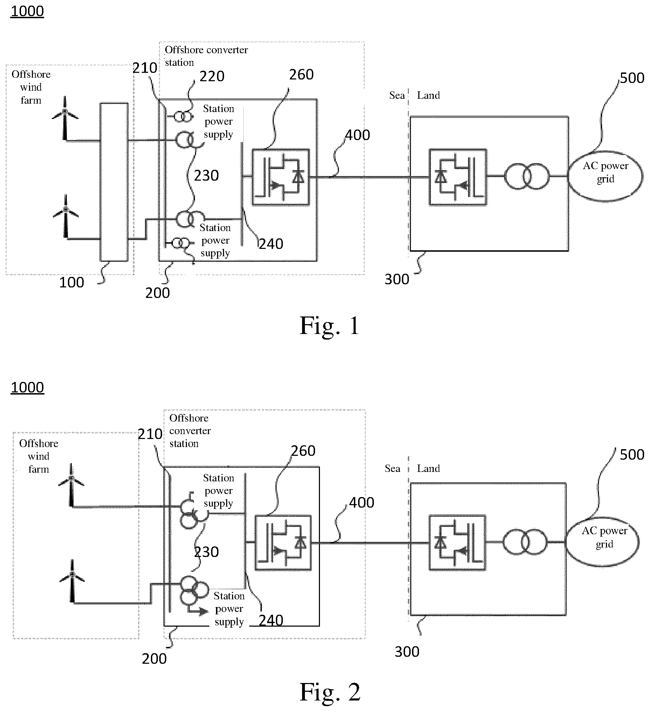

Fig. 1 is a diagram showing the composition of an offshore wind power output DC system according to a first exemplary embodiment of the present application. Fig. 2 is a diagram showing the composition of an offshore wind power output DC system according to a second exemplary embodiment of the present application.

As shown in Figs. 1 and 2, the offshore wind power output DC system 1000 generally comprises an AC booster station 100 (not shown in Fig. 2), an offshore flexible DC transmission converter station 200 (hereinafter referred to as offshore converter station) and an onshore converter station 300. Electricity generated by an offshore wind farm is boosted by the AC booster station 100 and connected to the offshore converter station 200. Direct current is output through the offshore converter station 200 and connected to the onshore converter station 300 through a submarine cable 400, thus realizing the transmission of wind farm power from the sea to an onshore AC power grid 500.

According to the first exemplary embodiment of the present application, referring to Fig. 1, the offshore converter station 200 may comprise an AC bus 210, a station transformer 220, a two-winding interconnecting transformer 230, a valve side bus 240, a valve side switch 250 (not shown), a equipment of converter valve and DC field 260, and corresponding measurement or control equipment. The equipment of converter valve and DC field 260 generally comprises a converter valve, a bridge arm reactor, DC field equipment, etc. In the process of power transmission, wind power generated by the offshore wind farm is boosted and connected to the AC bus 210 of the offshore converter station 200. The AC bus 210 is connected to the valve side bus 240 through two sets of parallel interconnecting transformers 230. The valve side bus 240 is connected to an AC side of the equipment of converter valve and DC field 260. The offshore converter station 200 supplies power to other equipment of the offshore converter station, such as an air conditioning system, through the high-voltage station transformer 220.

According to the second exemplary embodiment of the present application, referring to Fig. 2, the offshore converter station 200 may also comprise an AC bus 210, a three-winding interconnecting transformer 230, a valve side bus 240, a valve side switch 250 (not shown), a equipment of converter valve and DC field 260, and corresponding measurement or control equipment. In the process of power transmission, wind power generated by the offshore wind farm is boosted and connected to the AC bus 210 of the offshore converter station 200. The AC bus 210 is connected to the valve side bus 240 through the three-winding interconnecting transformer 230. The valve side bus 240 is connected to an AC side of the equipment of converter valve and DC field 260. The offshore converter station 200 supplies power to other equipment of the offshore converter station, such as an air conditioning system, through a third low-voltage winding of the three-winding interconnecting transformer 230.

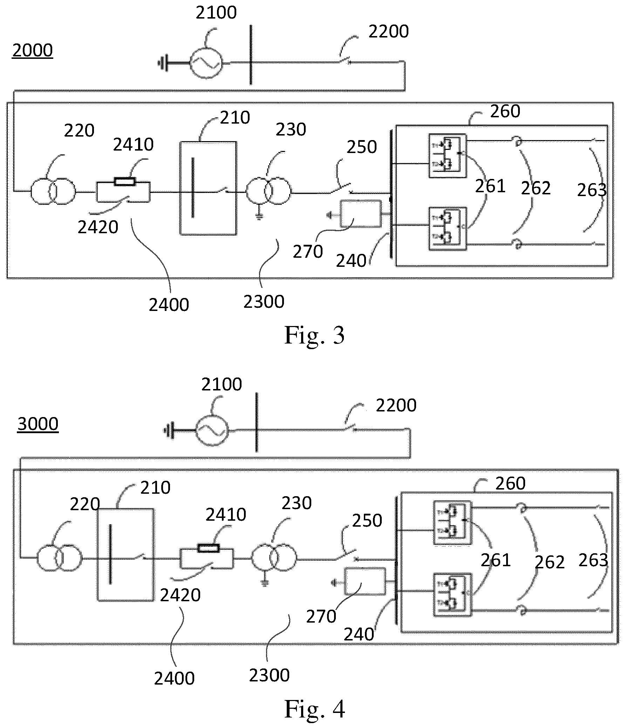

Fig. 3 is a diagram showing the composition of a test system for a flexible DC transmission converter station according to the first exemplary embodiment of the present application.

As shown in Fig. 3, according to the first exemplary embodiment, the present application provides a test system 2000 for a flexible DC transmission converter station, which is applied to the offshore flexible DC transmission converter station shown in Fig. 1. The test system 2000 comprises a test power supply 2100, a low-voltage AC switch 2200, a station transformer 220, a two-winding interconnecting transformer 230, an AC bus 210, and a equipment of converter valve and DC field 260. In order to reduce the loss of the test power supply at a test site, the test system 2000 comprises a single two-winding interconnecting transformer. The equipment of converter valve and DC field 260 generally comprises a converter valve 261, a bridge reactor 262, DC field equipment 263 and corresponding measurement or control equipment.

Referring to Fig. 3, in the test system 2000, the test power supply 2100 at the test site is connected to a low-voltage winding of the station transformer 220 through the low-voltage AC switch 2200. A first winding of the two-winding interconnecting transformer 230 can be directly connected to a high-voltage winding of the station transformer 220 or connected to the high-voltage winding of the station transformer 220 through the AC bus 210. In the exemplary embodiment of the present application, the first winding of the two-winding interconnecting transformer 230 is connected to the high-voltage winding of the station transformer 220 through the AC bus 210. In this exemplary embodiment, the two-winding interconnecting transformer 230, the station transformer 220 and the AC bus 210 are used as a transformation device to convert the voltage of the test power supply.

According to the exemplary embodiment of the present application, the AC bus 210 is a bus with an AC switch 211. In other embodiments, the AC bus 210 may be a bus without an AC switch.

The equipment of converter valve and DC field 260 can be directly connected to a second winding of the two-winding interconnecting transformer 230, or connected to the second winding of the two-winding interconnecting transformer 230 through the valve side bus 240. As shown in Fig. 3, in the exemplary embodiment of the present application, the equipment of converter valve and DC field 260 is connected to the second winding of the two-winding interconnecting transformer 230 through the valve side bus 240. The valve side bus 240 may be a bus with the valve side switch 250 or a bus without the valve side switch 250. In the exemplary embodiment of the present application, the valve side bus 240 is a bus with a valve side switch 250. Specifically, the valve side switch 250 is connected to the second winding of the two-winding interconnecting transformer 230. The valve side bus 240 is connected to the valve side switch 250. The equipment of converter valve and DC field 260 is connected to the valve side bus 240. According to the embodiment of the present application, the AC bus 210 is connected to the interconnecting transformer 230 by 3/2 connection or double-bus connection.

According to the embodiment of the present application, a voltage level of the test power supply 2100 matches a voltage level of the low-voltage winding of the station transformer 220, so as to provide a suitable test power supply for the test system. The test power supply 2100 comprises one of an existing or boosted 10 kV power supply, 20 kV power supply, 35 kV power supply and 110 kV power supply at the location of the test system 2000. For example, other power supplies on the site are boosted by diesel generators to the above-mentioned voltage. A low-voltage test power supply is transformed into high-voltage power required for the test by the station transformer 220, which realizes the purpose of high-voltage testing of converter station equipment by low-voltage access. For example, a 10 kV low-voltage incoming line of an offshore converter station platform installation and test site can be used to generate high voltage at a valve side of the interconnecting transformer, and DC side voltage can reach 0.7 times of rated DC voltage. Taking ±320 kV commonly used in Europe as an example, voltage across an anode and a cathode of a DC side can reach 448 kV, so as to fully monitor the main equipment of the converter station on land.

As shown in Fig. 3, the test system 2000 also comprises a resistor assembly 2400. The resistor assembly 2400 comprises a resistor 2410 and a resistor parallel switch 2420 connected in parallel with the resistor. The resistor assembly 2400 is connected between the high-voltage winding of the station transformer 220 and the first winding of the two-winding interconnecting transformer 230. According to the exemplary embodiment shown in Fig. 3, the resistor assembly 2400 is arranged before the AC bus 210. A resistance value of the resistor 2410 can range from 50 Ω to 20,000 Ω. Connecting the resistor assembly 2400 between the high-voltage winding of the station transformer 220 and the first winding of the two-winding interconnecting transformer 230 can effectively reduce the power demand of the test system 2000 for the test power supply.

In the above test system 2000, the station transformer 220, the AC bus 210, the two-winding interconnecting transformer 230, the valve side switch 250, the valve side bus 240, the converter valve 261, the bridge arm reactor 262, the DC field equipment 263 and the corresponding measurement or control equipment are all the equipment of the offshore converter station 200 itself, and are also equipment actually used for engineering. The test system provided in the present application makes full use of the existing equipment of the offshore converter station, and does not need to configure additional large-scale equipment to build a test platform.

As shown in Fig. 3, in the test system 2000, the station transformer 220, the AC bus 210, the two-winding interconnecting transformer 230, the valve side switch 250, the valve side bus 240, the converter valve 261, the bridge arm reactor 262, the DC field equipment 263, the resistor 2410 and the resistor parallel switch 2420 actually used for engineering constitute converter station equipment 2300, which is the primary equipment of the test system. The test system also comprises a secondary equipment (not shown), which is correspondingly connected to the primary equipment and used for measuring or controlling the primary equipment. For example, the secondary equipment is connected to the station transformer and the resistor assembly, so as to check the wiring and control relationship between the secondary equipment and the primary equipment during the test.

As shown in Fig. 3, the test system 2000 further comprises a grounding device 270, which is arranged between the second winding of the two-winding interconnecting transformer 230 and the equipment of converter valve and DC field 260, and serves as a clamping potential, so that a voltage potential at a valve side is balanced. The grounding mode may be small capacitance grounding or star reactance plus resistance grounding.

Fig. 4 is a diagram showing the composition of a test system for a flexible DC transmission converter station according to the second exemplary embodiment of the present application.

As shown in Fig. 4, according to another embodiment, the present application provides a test system 3000 for a flexible DC transmission converter station, which is applied to the offshore flexible DC transmission converter station shown in Fig. 1. The composition of the test system 3000 is basically the same as that of the test system 2000 in Fig. 3, except the position of the resistor assembly 2400.

As shown in Fig. 4, the resistor assembly 2400 is connected between the high-voltage winding of the station transformer 220 and the first winding of the two-winding interconnecting transformer 230. Unlike the embodiment in Fig. 3, the resistor assembly 2400 is arranged after the AC bus 210. The high-voltage winding of the station transformer 220 is connected to the AC bus 210. In this case, the resistance value of the resistor 2410 may also range from 50 Ω to 20,000 Ω.

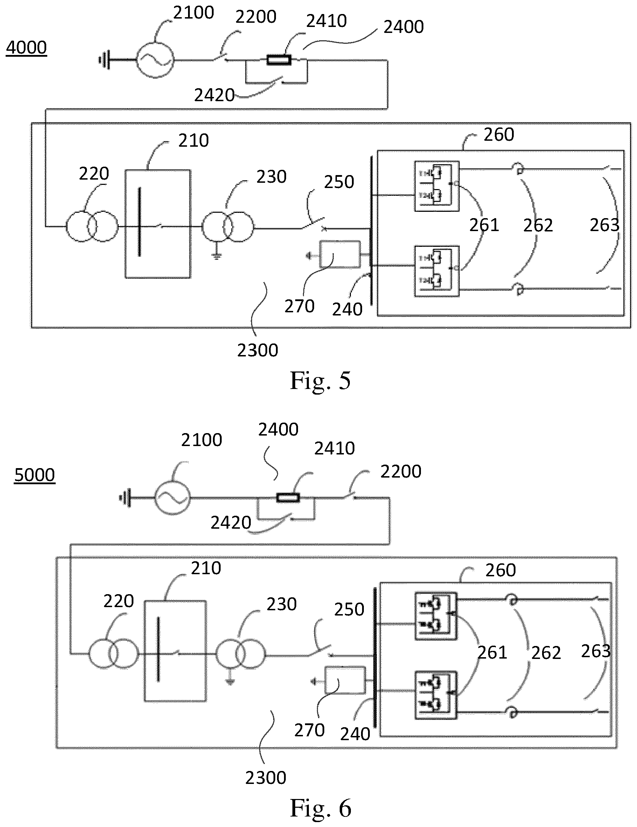

Fig. 5 is a diagram showing the composition of a test system for a flexible DC transmission converter station according to a third exemplary embodiment of the present application.

As shown in Fig. 5, according to another embodiment, the present application provides a test system 4000 for a flexible DC transmission converter station, which is applied to the offshore flexible DC transmission converter station shown in Fig. 1. The composition of the test system 4000 is basically the same as that of the test system 2000 in Fig. 3, except the position of the resistor assembly 2400.

As shown in Fig. 5, the resistor assembly 2400 is arranged between the low-voltage winding of the station transformer 220 and the test power supply 2100. Specifically, the resistor assembly 2400 is arranged after the low-voltage AC switch 2200. The test power supply 2100 is connected to the resistor assembly 2400 through the low-voltage AC switch 2200. In this case, the resistance value of the resistor 2410 may range from 5 Ω to 2000 Ω. According to some embodiments of the present application, the resistor 2410 may further comprise an inductance element connected in series with the resistor 2410. The inductance of the inductance element may range from 1 mH to 1 H.

Fig. 6 is a diagram showing the composition of a test system for a flexible DC transmission converter station according to a fourth exemplary embodiment of the present application.

As shown in Fig. 6, according to another embodiment, the present application provides a test system 5000 for the offshore flexible DC transmission converter station shown in Fig. 1. The composition of the test system 5000 is basically the same as that of the test system 4000 in Fig. 5, except the position of the resistor assembly 2400.

As shown in Fig. 6, the resistor assembly 2400 is arranged between the low-voltage winding of the station transformer 220 and the test power supply 2100. Specifically, the resistor assembly 2400 is arranged before the low-voltage AC switch 2200. The test power supply 2100 is directly connected to the resistor assembly 2400. In this case, the resistance value of the resistor 2410 may range from 5 Ω to 2000 Ω. According to some embodiments of the present application, the resistor 2410 may further comprise an inductance element connected in series with the resistor 2410. An inductance value of the inductance element may range from 1 mH to 1 H.

According to other embodiments of the present application, the resistor assembly in the test system may also be connected between the second winding of the two-winding interconnecting transformer and the equipment of converter valve and DC field, and the composition of the system is the same as that of the above test system, which is not repeated here.

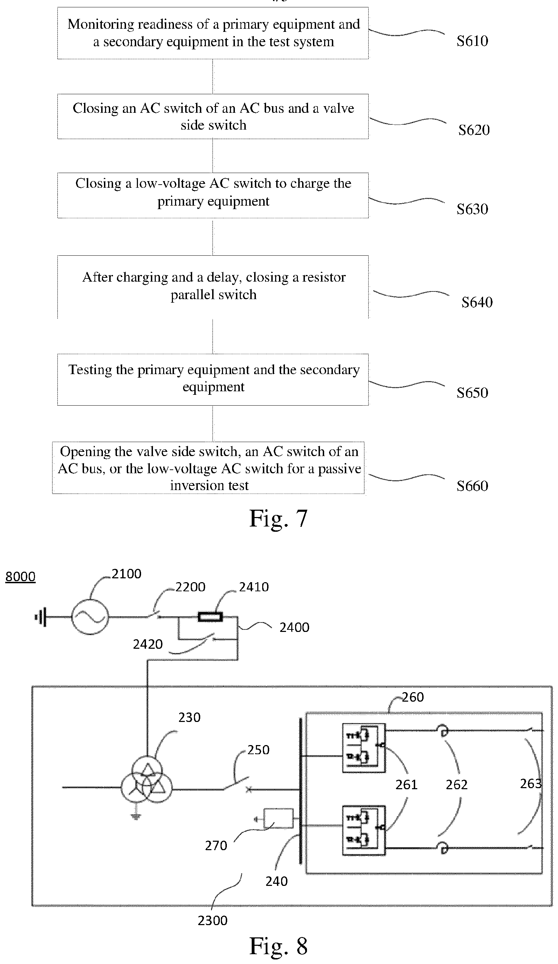

Fig. 7 is a flowchart of a test method for a flexible DC transmission converter station according to an exemplary embodiment of the present application.

As shown in Fig. 7, according to the exemplary embodiment, the test method for a flexible DC transmission converter station provided in the present application is applied to the test systems shown in Figs. 3 to 6, and comprises:
S610, monitoring the readiness of a primary equipment and a secondary equipment in the test system. Wherein when all the equipment in the test system is ready, the test can be started.
S620, closing an AC switch 211 of an AC bus and a valve side switch 250.
S630, closing a low-voltage AC switch 2200 to charge the primary equipment. Wherein after the low-voltage AC switch 2200 is closed, the main equipment of the converter station can be charged at high voltage through a resistor 2410.
S640, after charging and a delay, closing a resistor parallel switch 2420 to further charge a equipment of converter valve and DC field 260 at high voltage. Wherein the delay may range from 5 s to 500 s.
S650, testing the primary equipment and the secondary equipment. Wherein the station transformer, the AC bus, the two-winding interconnecting transformer, the valve side switch, the valve side bus, the converter valve, the bridge arm reactor, the DC field equipment and the corresponding measurement or control equipment are tested to check the correctness of connection. For example, the DC voltage is checked, and when the DC voltage is greater than 0.5 times the rated DC voltage or the valve side voltage is greater than 0.7 times the rated valve side voltage, the voltage and insulation tolerance of related equipment are checked.
S660, opening the valve side switch 250 or the AC switch 211 of the AC bus 210 or the low-voltage AC switch 2200 for a passive inversion test. Wherein the specific passive inversion test process is as follows: after the power supply is turned off, the voltage of the valve side bus 240 is inverted after the converter valve 261, the bridge arm reactor 262 and the DC field equipment 263 are executed by a given constant reference wave and unlocking signal, and in this process, the correctness of execution of the two-winding interconnecting transformer 230, the valve side switch 250, the valve side bus 240, the converter valve 261, the bridge arm reactor 262 and the DC field equipment 263 under the control of the measurement or control equipment is checked.

In addition, during the above test, an active charging test can also be performed on the equipment of converter valve and DC field 260 to monitor the functional integrity of the converter valve and a valve control system. After active charging, a short-term active unlocking test can be performed on the converter valve when the power supply in the test site is running. The above test method can verify the correctness of connection and control of the control system and main equipment, such as the station transformer, the AC bus, the interconnecting transformer, the valve side switch, the valve side bus, the converter valve, the bridge arm reactor, the DC field equipment, etc., to ensure the correctness of the control system to the main equipment, and avoid transportation, installation and testing between the land and the sea after problems are found in an offshore test, thus saving space, time and cost.

Fig. 8 is a diagram showing the composition of a test system for a flexible DC transmission converter station according to a fifth exemplary embodiment of the present application.

As shown in Fig. 8, according the exemplary embodiment, the present application provides a test system 8000 for a flexible DC transmission converter station, which is applied to the offshore flexible DC transmission converter station shown in Fig. 2. The test system 8000 comprises a test power supply 2100, a low-voltage AC switch 2200, a three-winding interconnecting transformer 230, a valve side bus 240, a valve side switch 250, and a equipment of converter valve and DC field 260. According to the exemplary embodiment of the present application, the equipment of converter valve and DC field 260 comprises a converter valve 261, a bridge reactor 262, DC field equipment 263 and corresponding measurement or control equipment.

Referring to Fig. 8, in the above test system 8000, the test power supply 2100 in the test site is connected to a third low-voltage winding of the three-winding interconnecting transformer 230 through the low-voltage AC switch 2200. The valve side switch 250 is connected to a second winding of the three-winding interconnecting transformer 230. The valve side bus 240 is connected to the valve side switch 250. The equipment of converter valve and DC field 260 is connected to the valve side bus 240. In this exemplary embodiment, the three-winding interconnecting transformer 230 is used as a voltage transforming device to convert the voltage of the test power supply.

A voltage level of the test power supply 2100 matches a voltage level of the third low-voltage winding of the three-winding interconnecting transformer 230, so as to provide a suitable test power supply for the test system. The test power supply 2100 comprises one of the existing or boosted 10 kV power supply, 20 kV power supply, 35 kV power supply and 110 kV power supply at the location of the test system 8000. For example, other existing power supplies are boosted by diesel generators to the above-mentioned voltage. A low-voltage test power supply is transformed into high-voltage power required for the test by the three-winding interconnecting transformer 230, which realizes the purpose of high-voltage testing of converter station equipment by low-voltage access. For example, a 10 kV low-voltage incoming line of an offshore converter station platform installation and test site can be used to generate high voltage at a valve side of the interconnecting transformer, and DC side voltage can reach 0.7 times of rated DC voltage. Taking ±320 kV commonly used in Europe as an example, voltage across an anode and a cathode of a DC side can reach 448 kV, so as to fully monitor the main equipment of the converter station on land.

As shown in Fig. 8, the test system 8000 also comprises a resistor assembly 2400. The resistor assembly 2400 comprises a resistor 2410 and a resistor parallel switch 2420 connected in parallel with the resistor. The resistor assembly 2400 is connected between the third low-voltage winding of the three-winding interconnecting transformer 230 and the test power supply 2100. According to the exemplary embodiment shown in Fig. 8, the resistor assembly 2400 is arranged after the low-voltage AC switch 2200. The test power supply 2100 is connected to the resistor assembly 2400 through the low-voltage AC switch 2200. A resistance value of the resistor 2410 can range from 5 Ω to 2000 Ω. Connecting the resistor assembly 2400 between the three-winding interconnecting transformer 230 and the test power supply 2100 can effectively reduce the power demand of the test system 8000 for the test power supply.

In the above test system 8000, the three-winding interconnecting transformer 230, the valve side switch 250, the valve side bus 240, the converter valve 261, the bridge arm reactor 262, the DC field equipment 263 and the corresponding measurement or control equipment are all the equipment of the offshore converter station 200 itself, and are also equipment actually used for engineering. The test system provided in the present application makes full use of the existing equipment of the offshore converter station, and does not need to configure additional large-scale equipment to build a test platform.

As shown in Fig. 8, in the above-mentioned test system 8000, the three-winding interconnecting transformer 230, the valve side switch 250, the valve side AC bus 240, the converter valve 261, the bridge arm reactor 262, the DC field equipment 263, the resistor 2410 and the resistor parallel switch 2420 actually used for engineering constitute converter station equipment 2300, which is the primary equipment of the test system. The test system 8000 also comprises a secondary equipment (not shown), which is correspondingly connected to the primary equipment and used for measuring or controlling the primary equipment. For example, the secondary equipment is connected to the three-winding interconnecting transformer and the resistor assembly, so as to check the wiring and control relationship between the secondary equipment and the primary equipment during the test.

As shown in Fig. 8, the test system 8000 further comprises a grounding device 270, which is arranged between the second winding of the three-winding interconnecting transformer 230 and the equipment of converter valve and DC field 260, and serves as a clamping potential, so that a voltage potential at a valve side is balanced. The grounding mode may be small capacitance grounding or star reactance plus resistance grounding.

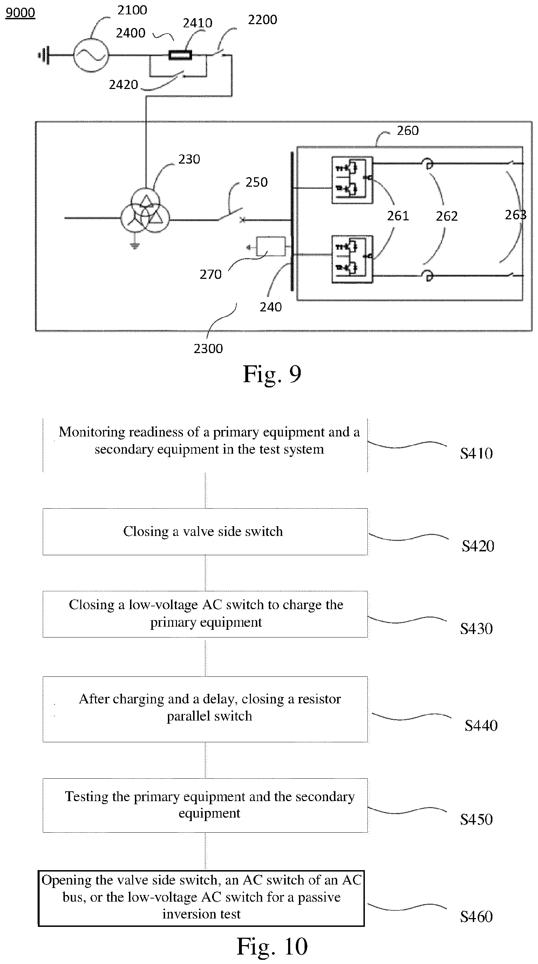

Fig. 9 is a diagram showing the composition of a test system for a flexible DC transmission converter station according to a sixth exemplary embodiment of the present application.

As shown in Fig. 9, according to another embodiment, the present application provides a test system 9000 for the offshore flexible DC transmission converter station shown in Fig. 2. The composition of the test system 9000 is basically the same as that of the test system 8000 in Fig. 8, except the position of the resistor assembly 2400.

As shown in Fig. 9, the resistor assembly 2400 is arranged between the third low-voltage winding of the three-winding interconnecting transformer 230 and the test power supply 2100. Specifically, the resistor assembly 2400 is arranged before the low-voltage AC switch 2200. The test power supply 2100 is directly connected to the resistor assembly 2400. A resistance value of the resistor 2410 can also range from 5 Ω to 2000 Ω. Similarly, connecting the resistor assembly 2400 between the three-winding interconnecting transformer 230 and the test power supply 2100 can effectively reduce the power demand of the test system 9000 for the test power supply.

Fig. 10 is a flowchart of a test method for a flexible DC transmission converter station according to the second exemplary embodiment of the present application.

As shown in Fig. 10, according to the exemplary embodiment, the test method for a flexible DC transmission converter station provided in the present application is applied to the test systems shown in Figs. 8 and 9, and comprises:
S410, monitoring the readiness of a primary equipment and a secondary equipment in the test system. Wherein when all the equipment in the test system is ready, the test can be started.
S420, closing a valve side switch 250.
S430, closing a low-voltage AC switch 2200 to charge the primary equipment. Wherein after the low-voltage AC switch 2200 is closed, the main equipment of the converter station can be charged at high voltage through a resistor 2410.

After charging and a delay, closing a resistor parallel switch 2420 to further charge a equipment of converter valve and DC field 260 at high voltage. Wherein the delay may range from 5 s to 100 s.

S450, testing the primary equipment and the secondary equipment. Wherein the three-winding interconnecting transformer, the valve side switch, the valve side bus, the converter valve, the bridge arm reactor, the DC field equipment and the corresponding measurement or control equipment are tested to check the correctness of connection.

S460, opening the valve side switch 250 or the low-voltage AC switch 2200 for a passive inversion test. Wherein the specific passive inversion test process is as follows: after the power supply is turned off, the voltage of the valve side bus 240 is inverted after the converter valve 261, the bridge arm reactor 262 and the DC field equipment 263 are executed by a given constant reference wave and unlocking signal, and in this process, the correctness of execution of the three-winding interconnecting transformer 230, the valve side switch 250, the valve side bus 240, the converter valve 261, the bridge arm reactor 262 and the DC field equipment 263 under the control of the measurement or control equipment is checked.

In addition, during the above test, an active charging test can also be performed on the equipment of converter valve and DC field 260 to monitor the functional integrity of the converter valve and a valve control system. The above test method can verify the correctness of connection and control of the control system and main equipment, such as the three-winding interconnecting transformer, the valve side switch, the valve side bus, the converter valve, the bridge arm reactor, the DC field equipment, etc., to ensure the correctness of the control system to the main equipment, and avoid transportation, installation and testing between the land and the sea after problems are found in an offshore test, thus saving space, time and cost.

The test system for a flexible DC transmission converter station provided by the present application directly uses the main equipment used when an offshore converter station is built on an offshore platform for testing, without additional equipment or changing the existing location. After testing, direct transportation to the sea can be performed. Except for the low-voltage AC switch, the resistor and the resistor parallel switch, there is no need for additional test sites to build test platforms. In addition, the test system provided by the present application can complete a high-voltage test of the main equipment of the converter station by using a 10 kV low-voltage incoming line of an onshore installation test site for the offshore converter station. Through the test, a system circuit and the main equipment are examined, and wiring and control functions of a converter station control system and the main equipment are verified too, so that problems can be solved on land, and the offshore testing time, engineering test cycle and cost can be reduced. Moreover, the test power supply is placed at a low-voltage end of the incoming line, so the requirement for the capacity of the test power supply is reduced.

Obviously, the above embodiments are only examples for clearly explaining the present application, and are not a limitation to the implementation. For those of ordinary skill in the art, other changes or modifications in different forms can be made on the basis of the above description. It is neither necessary nor possible to exhaust all the embodiments here. However, the obvious changes or modifications drawn thereout are still within the scope of protection of the present application.

## Claims

1. A test system for a flexible DC transmission converter station, comprising:
a test power supply at a test site;
a voltage transforming device connected to the test power supply through a low-voltage AC switch;
an equipment of converter valve and DC field connected to the voltage transforming device; and
a resistor assembly being connected between the test power supply and the voltage transforming device, or between the voltage transforming device and the equipment of converter valve and DC field, and comprising a resistor and a resistor parallel switch connected in parallel with the resistor.

2. The test system of claim 1, wherein the voltage transforming device comprises a two-winding interconnecting transformer, a station transformer and an AC bus,
the test power supply is connected to a low-voltage winding of the station transformer through the low-voltage AC switch,
a first winding of the two-winding interconnecting transformer is connected to a high-voltage winding of the station transformer through the AC bus,
the equipment of converter valve and DC field is connected to a second winding of the two-winding interconnecting transformer, and
the resistor assembly is connected between the low-voltage winding of the station transformer and the test power supply, between the high-voltage winding of the station transformer and the first winding of the two-winding interconnecting transformer, or between the second winding of the two-winding interconnecting transformer and the equipment of converter valve and DC field.

3. The test system of claim 2, wherein a voltage level of the test power supply matches a voltage level of the low-voltage winding of the station transformer.

4. The test system of claim 3, wherein the resistor assembly is connected between the high-voltage winding of the station transformer and the first winding of the two-winding interconnecting transformer, the resistor assembly is arranged before or after the AC bus, and a resistance value of the resistor ranges from 50 Ω to 20,000 Ω.

5. The test system of claim 3, wherein the resistor assembly is connected between the low-voltage winding of the station transformer and the test power supply, the resistor assembly is arranged before or after the low-voltage AC switch, and a resistance value of the resistor ranges from 5 Ω to 2,000 Ω.

6. The test system of claim 2, wherein the AC bus comprises a bus with an AC switch or a bus without an AC switch.

7. The test system of claim 2, wherein the AC bus is connected to the first winding of the two-winding interconnecting transformer by 3/2 connection or double-bus connection.

8. The test system of claim 2, wherein the equipment of converter valve and DC field is connected to the second winding of the two-winding interconnecting transformer through a valve side bus, and
the valve side bus comprises a bus with a valve side switch or a bus without a valve side switch.

9. The test system of claim 2, wherein the station transformer, the interconnecting transformer, the equipment of converter valve and DC field and the resistor assembly constitute a primary equipment of the test system, and the test system further comprises:
a secondary equipment correspondingly connected to the primary equipment and used for measuring or controlling the primary equipment.

10. The test system of claim 1, wherein the voltage transformation device comprises a three-winding interconnecting transformer, and the test system further comprises a valve side switch and a valve side bus; and
the test power supply is connected to a third low-voltage winding of the three-winding interconnecting transformer through the low-voltage AC switch,
the valve side switch is connected to a second winding of the three-winding interconnecting transformer,
the valve side bus is connected to the valve side switch,
the equipment of converter valve and DC field is connected to the valve side bus, and
the resistor assembly is connected between the third low-voltage winding of the three-winding interconnecting transformer and the test power supply.

11. The test system of claim 10, wherein a voltage level of the test power supply matches a voltage level of the third winding of the three-winding interconnecting transformer.

12. The test system of claim 11, wherein the resistor assembly is arranged before or after the low-voltage AC switch, and a resistance value of the resistor ranges from 5 Ω to 2,000 Ω.

13. The test system of claim 10, wherein the three-winding interconnecting transformer, the valve side switch, the valve side bus, the equipment of converter valve and DC field and the resistor assembly constitute a primary equipment of the test system, and the test system further comprises:
a secondary equipment correspondingly connected to the primary equipment and used for measuring or controlling the primary equipment.

14. The test system of claim 1, further comprising:
a grounding device arranged between the voltage transformation device and the equipment of converter valve and DC field.

15. The test system of claim 14, wherein the grounding device adopts small capacitance grounding or star reactance plus resistance grounding.

16. The test system of claim 1, wherein the flexible DC transmission converter station is used as an offshore flexible DC transmission converter station.

17. The test system of claim 1, wherein the test power supply comprises:
one of an existing or boosted 10 kV power supply, 20 kV power supply, 35 kV power supply and 110 kV power supply at a location of the test system.

18. A test method for a flexible DC transmission converter station, wherein
the test method is applied to the test system of any one of claims 2-9 and comprises:
monitoring readiness of a primary equipment and a secondary equipment in the test system;
closing an AC switch of the AC bus and a valve side switch;
closing the low-voltage AC switch to charge the primary equipment;
after charging and a delay, closing a resistor parallel switch to further charge the equipment of converter valve and DC field;
testing the primary equipment and the secondary equipment; and
opening the valve side switch, the AC switch of the AC bus, or the low-voltage AC switch for a passive inversion test;
alternatively, the test method is applied to the test system of any one of claims 10-13 and comprises:
monitoring readiness of a primary equipment and a secondary equipment in the test system;
closing the valve side switch;
closing the low-voltage AC switch to charge the primary equipment;
after charging and a delay, closing a resistor parallel switch to further charge the equipment of converter valve and DC field;
testing the primary equipment and the secondary equipment; and
opening the valve side switch, an AC switch of an AC bus, or the low-voltage AC switch for a passive inversion test.

19. The test method of claim 18, wherein the delay ranges from 5 s to 500 s.

20. The test method of claim 18, further comprising:
performing an active charging test on the equipment of converter valve and DC field.
